# EUROPEAN PATENT SPECIFICATION

(11) **EP 3 666 935 B1**
(45) Date of publication and mention of the grant of the patent: **22.05.2024**
(21) Application number: 18922090.8
(22) Date of filing: 26.12.2018
(51) Int. Cl.: C30B 23/02, C30B 29/36, C30B 33/02

(54) **HIGH-PURITY SILICON CARBIDE SINGLE CRYSTAL SUBSTRATE AND PREPARATION METHOD THEREFOR**
EINKRISTALLSUBSTRAT AUS HOCHREINEM SILICIUMCARBID UND VERFAHREN ZU SEINER HERSTELLUNG
SUBSTRAT MONOCRISTALLIN DE CARBURE DE SILICIUM DE HAUTE PURETÉ ET SON PROCÉDÉ DE PRÉPARATION

(30) Priority: 16.10.2018 CN 201811204666; 16.10.2018 CN 201811205277
(43) Date of publication of application: 17.06.2020
(73) Proprietor: SICC CO., LTD., Jinan, Shandong 250118 (CN)
(72) Inventor: GAO, Chao, Jinan, Shandong 250100 (CN); BAI, Wenwen, Jinan, Shandong 250100 (CN); ZHANG, Hongyan, Jinan, Shandong 250100 (CN); DOU, Wentao, Jinan, Shandong 250100 (CN)
(74) Representative: Huang, Liwei
(86) International application number: PCT/CN2018/123710
(87) International publication number: WO 2020/077848

(56) References cited:
- WO-A1-2009/080177
- WO-A1-2012/156792
- CN-A- 1 351 680
- CN-A- 1 663 033
- CN-A- 1 695 253
- CN-A- 105 821 471
- CN-A- 106 757 357
- CN-A- 107 723 798
- CN-A- 108 130 592
- US-B1- 8 617 965

## Description

### TECHNICAL FIELD

The present application relates to a high-purity silicon carbide single crystal substrate and a preparation method and application thereof, and belongs to the field of semiconductor materials.

### BACKGROUND

A semi-insulating silicon carbide (SiC) single crystal substrate is a preferred semiconductor base material for preparing a GaN-based high-frequency microwave device, which, on one hand, depends on excellent properties such as high resistivity of the semi-insulating silicon carbide single crystal substrate that can be used in preparation of electron devices with excellent performance, and on the other hand, depends on a higher fit of lattice constants of SiC and GaN that can make a heteroepitaxial layer obtain good crystal quality.

In terms of an implementation method, the semi-insulating silicon carbide single crystal substrate is prepared in two modes of doping and highly purifying. A large number of deep-energy-level centers are introduced by doping a high-concentration vanadium element, to pin the Fermi level at a center of a forbidden band, so as to implement a semi-insulation property. At present, studies have shown that doping of high-concentration vanadium will capture electrons in a device prepared, causing a back gate effect, which reduces or even invalidates device performance. With technology development, it has become a mainstream to reduce a concentration of effective carriers in the crystal by reducing a concentration of shallow-energy-level impurities in the crystal, and simultaneously introducing a certain amount of intrinsic point defects as the deep-energy-level center for compensation, so as to implement a high-purity semi-insulating silicon carbide single crystal substrate having a semi-insulation property.

A high-resistance characteristic of the high-purity semi-insulating silicon carbide single crystal substrate is implemented on a basis of a low concentration of electroactive impurities inside the crystal and a certain concentration of intrinsic point defects such as carbon vacancies and their composites. The intrinsic point defect is an indispensable feature for implementing electrical properties of high-purity semi-insulating crystals; however, these point defects themselves introduce a relatively large lattice stress, causing lattice distortion, thus destroying integrity of a silicon carbide single crystal lattice, which affects lattice parameters of the silicon carbide single crystal to a certain extent. Considering that one of main reasons that GaN uses a silicon carbide single crystal substrate as an epitaxy is just a smaller mismatch between the lattice parameters of the two, and introduction of point defects will increase lattice mismatch of GaN and SiC, which further reduces quality of a GaN epitaxial layer.

Some prior arts regarding a silicon carbide single crystal substrate as well as a production method thereof can be seen in WO2012/156792A1, WO2009/080177A1, and US8617965B1.

### SUMMARY

The invention is set out in the appended set of claims.

The present application provides a high-purity silicon carbide single crystal substrate. The high-purity silicon carbide single crystal substrate according to the present application balances a relationship between crystal quality of the GaN epitaxial layer and electrical properties of a high-purity silicon carbide crystal, and improves quality of the high-purity silicon carbide single crystal substrate and its lattice fit with the GaN epitaxial layer, without affecting implementation of physical properties of the high-purity semi-insulating silicon carbide single crystal substrate.

The high-purity silicon carbide single crystal substrate at least comprises a silicon carbide single crystal substrate surface layer and a silicon carbide single crystal substrate main body layer; an intrinsic point defect concentration of the silicon carbide single crystal substrate surface layer is smaller than an intrinsic point defect concentration of the silicon carbide single crystal substrate main body layer; and the silicon carbide single crystal substrate has a semi-insulation property.

Optionally, a ratio of a thickness of the silicon carbide single crystal substrate surface layer to a thickness of the silicon carbide single crystal substrate main body layer is 1:4 to 1:25.

Optionally, the high-purity silicon carbide single crystal substrate is composed of the silicon carbide single crystal substrate surface layer and the silicon carbide single crystal substrate main body layer. Further, the high-purity silicon carbide single crystal substrate is composed of a silicon carbide single crystal substrate surface and a silicon carbide single crystal substrate main body layer.

Optionally, a ratio of the thickness of the silicon carbide single crystal substrate surface layer to a thickness of the silicon carbide single crystal substrate is not greater than 31%. Further, the ratio of the thickness of the silicon carbide single crystal substrate surface layer to the thickness of the silicon carbide single crystal substrate is 9% to 31%. Further, the ratio of the thickness of the silicon carbide single crystal substrate surface layer to the thickness of the silicon carbide single crystal substrate has a lower limit selected from 10%, 15%, 20%, 25% or 30%, and an upper limit selected from 10%, 15%, 20%, 25% or 30%.

Optionally, a thickness of the semi-insulating silicon carbide single crystal substrate is 490 µm to 510 µm.

Optionally, the intrinsic point defect concentration of the silicon carbide single crystal substrate surface layer at room temperature is not higher than 1×10¹² cm⁻³.

Optionally, the intrinsic point defect concentration of the silicon carbide single crystal substrate main body layer is 1×10¹⁴ cm⁻³to 1×10¹⁵ cm⁻³.

Optionally, a thickness of the semi-insulating silicon carbide single crystal substrate surface layer is not greater than 150 µm. Optionally, the thickness of the semi-insulating silicon carbide single crystal substrate surface layer is 20 µm to 150 µm. In particular, a thickness of an annealed surface layer of the high-purity silicon carbide single crystal substrate is 50 µm to 150 µm. Further, the thickness of the annealed surface layer of the high-purity silicon carbide single crystal substrate has a lower limit selected from 55 µm, 70 µm, 90 µm, 110 µm, 130 µm or 140 µm, and an upper limit selected from 55 µm, 70 µm, 90 µm, 110 µm, 130 µm or 140 µm. Further, the thickness of the annealed surface layer of the high-purity silicon carbide single crystal substrate is 80 µm to 120 µm.

Optionally, the silicon carbide single crystal substrate surface layer has substantially no intrinsic point defects at room temperature, and the silicon carbide single crystal substrate main body layer has an intrinsic point defect concentration such that the high-purity silicon carbide single crystal substrate has a semi-insulation property.

Optionally, the silicon carbide single crystal substrate surface layer contains only intrinsic point defects inherent at room temperature, and the silicon carbide single crystal substrate main body layer has an intrinsic point defect concentration such that the high-purity silicon carbide single crystal substrate has a semi-insulation property.

As an implementation mode, the silicon carbide single crystal substrate surface layer has substantially no intrinsic point defects at room temperature; the intrinsic point defect concentration of the silicon carbide single crystal substrate main body layer is 1×10¹⁴ cm⁻³ to 1×10¹⁶ cm⁻³; and a thickness ratio of the silicon carbide single crystal substrate surface layer to the silicon carbide single crystal substrate main body layer in the high-purity silicon carbide single crystal substrate is 1:4 to 1:25. That the silicon carbide single crystal substrate surface layer has substantially no intrinsic point defects at room temperature refers to that the intrinsic point defect concentration is extremely low; there are always intrinsic point defects present in the crystal unless at the absolute zero degree, and the defect has a lowest concentration within a certain thickness.

In particular, a lattice of the silicon carbide single crystal of the silicon carbide single crystal substrate surface layer has complete integrity.

Optionally, a concentration of shallow-energy-level impurities in the silicon carbide single crystal substrate is 1×10¹⁴ cm⁻³ to 1×10¹⁶ cm⁻³. Further, the shallow-energy-level impurities include at least one of N, B and Al.

Optionally, the high-purity silicon carbide single crystal substrate is prepared by using a method comprising steps of: performing a high-temperature rapid heat treatment and a surface annealing treatment on a high-purity silicon carbide single wafer, to obtain the high-purity silicon carbide single crystal substrate.

Optionally, the high-temperature rapid heat treatment includes a rapid heating stage and a rapid cooling stage.

In particular, the rapid heating stage includes treatment conditions below: raising a temperature to 1,800 °C to 2,300 °C at a rate of 30 °C/s to 100 °C/s, holding for 60 s to 600 s; and the rapid cooling stage includes treatment conditions below: rapidly cooling to room temperature at a rate of 50 °C/s to 150 °C/s.

Further, a heating rate of the rapid heating stage is 50 °C/s to 80 °C/s.

Further, the rapid heating stage has a holding temperature of 2,000 °C to 2,200 °C, and a holding period of 100 s to 500 s. Further, the rapid heating stage has a holding temperature of 2,000 °C to 2,100 °C, and a holding period of 150 s to 200 s.

Further, the rapid cooling stage includes: rapidly cooling at a rate of 50 °C/s to 150 °C/s. Further, the rapid cooling stage includes: rapidly cooling at a rate of 100 °C/s to 150 °C/s. The rapid cooling stage can freeze intrinsic point defects injected in the rapid heating stage into the crystal.

In the present application, a certain amount of intrinsic point defects are injected into the silicon carbide single wafer by the high-temperature rapid heat treatment, to avoid annihilation of excessive intrinsic point defects during a subsequent surface annealing process that affects the semi-insulation property of the prepared silicon carbide single crystal substrate.

In particular, the surface annealing treatment has a surface temperature of the silicon carbide single wafer controlled at 1,200 °C to 1,800 °C, and an annealing treatment period for 30 min to 90 min.

Further, the surface temperature of the high-purity silicon carbide single wafer controlled in the surface annealing treatment has a lower limit selected from 1,250 °C, 1,300 °C, 1,400 °C, 1,500 °C, 1,600 °C, 1,700 °C or 1,750 °C, and an upper limit selected from 1,250 °C, 1,300 °C, 1,400 °C, 1,500 °C, 1,600 °C, 1,700 °C or 1,750 °C.

Further, the period controlled in the surface annealing treatment of the high-purity silicon carbide single wafer has a lower limit selected from 35 min, 45 min, 55 min, 65 min, 75 min or 85 min, and an upper limit selected from 35 min, 45 min, 55 min, 65 min, 75 min or 85 min.

In particular, the surface annealing treatment has a surface temperature of the high-purity silicon carbide single wafer controlled at 1,400 °C to 1,600 °C, and an annealing treatment period for 45 min to 60 min. Further, the surface annealing treatment has a surface temperature of the high-purity silicon carbide single wafer controlled at 1,500 °C to 1,600 °C.

In particular, the surface annealing treatment is heating, by a surface laser, a surface of the silicon carbide single wafer subjected to the high-temperature rapid heat treatment; the laser heating step includes: performing reciprocating surface scanning by a laser on the silicon carbide single wafer subjected to the high-temperature rapid heat treatment to perform the surface annealing treatment, a laser movement rate being 0.5 mm/s to 3,000 mm/s.

Further, the laser movement rate has a lower limit selected from 1 mm/s, 1,000 mm/s, 1,500 mm/s, 2,000 mm/s or 2,500 mm/s, and an upper limit selected from 5 mm/s, 1,000 mm/s, 1,500 mm/s, 2,000 mm/s or 2,500 mm/s. Further, the laser movement rate is 0.5 mm/s to 5 mm/s. The laser movement rate is such that the laser can heat the substrate surface to a preset temperature but the temperature is not rapidly conducted to the interior of the silicon carbide single crystal substrate, so as to achieve an annealing effect on the surface of the silicon carbide single crystal substrate.

Optionally, the surface annealing treatment includes at least annealing one surface of the silicon carbide single wafer. Further, the surface annealing treatment includes annealing a contact surface with a GaN crystal when the silicon carbide single crystal substrate grows the GaN crystal.

Optionally, the surface annealing treatment is heating, by a laser, a surface of the silicon carbide single wafer subjected to the high-temperature rapid heat treatment.

Optionally, the laser has a wavelength less than 352 nm, a pulse width not greater than 60 ns, and an energy density not greater than 150 mJ/cm². In particular, the laser has a wavelength less than 352 nm, a pulse width of 20 ns to 60 ns, and an energy density of 70 mJ/cm² to 110 mJ/cm². The high-purity silicon carbide single wafer surface treated by using the parameters of the laser according to the present application has high uniformity.

According to another aspect of the present application, there is provided a semiconductor device, comprising the high-purity silicon carbide single crystal substrate according to any one of the above.

In particular, the semiconductor device is an epitaxial wafer or a transistor.

According to still another aspect of the present application, there is provided use of the high-purity silicon carbide single crystal substrate according to any one of the above in preparation of a semiconductor device.

In particular, the semiconductor device is an epitaxial wafer or a transistor.

According to yet another aspect of the present application, there is provided a preparation method of a high-quality semi-insulating silicon carbide single crystal substrate. The preparation method according to the present application balances a relationship between crystal quality of a GaN epitaxial layer and electrical properties of a high-purity silicon carbide crystal. The preparation method of the novel high-purity semi-insulating silicon carbide substrate improves quality of the semi-insulating silicon carbide single crystal substrate and its lattice fit with the GaN epitaxial layer, without affecting implementation of physical properties of the high-purity semi-insulating silicon carbide single crystal substrate.

The preparation method of the high-quality semi-insulating silicon carbide single crystal substrate comprises steps of:
1) Selecting a high-purity silicon carbide single wafer;
2) Performing a high-temperature rapid heat treatment and a surface annealing treatment on the high-purity silicon carbide single wafer to obtain the high-quality semi-insulating silicon carbide single crystal substrate; the high-quality semi-insulating silicon carbide single crystal substrate at least comprising a silicon carbide single crystal substrate surface layer and a silicon carbide single crystal substrate main body layer.

Optionally, a ratio of a thickness of the silicon carbide single crystal substrate surface layer to a thickness of the silicon carbide single crystal substrate is not greater than 31%. Further, the ratio of the thickness of the silicon carbide single crystal substrate surface layer to the thickness of the silicon carbide single crystal substrate is 9% to 31%. Further, the ratio of the thickness of the silicon carbide single crystal substrate surface layer to the thickness of the silicon carbide single crystal substrate has a lower limit selected from 10%, 15%, 20%, 25% or 30%, and an upper limit selected from 10%, 15%, 20%, 25% or 30%.

Optionally, a thickness of the semi-insulating silicon carbide single crystal substrate is 490 µm to 510 µm.

Optionally, a thickness of the semi-insulating silicon carbide single crystal substrate surface layer is not greater than 150 µm. In particular, a thickness of an annealed surface layer of the semi-insulating silicon carbide single crystal substrate is 20 µm to 150 µm. In particular, a thickness of the annealed surface layer of the semi-insulating silicon carbide single crystal substrate is 50 µm to 150 µm. Further, the thickness of the annealed surface layer of the semi-insulating silicon carbide single crystal substrate has a lower limit selected from 55 µm, 70 µm, 90 µm, 110 µm, 130 µm or 140 µm, and an upper limit selected from 55 µm, 70 µm, 90 µm, 110 µm, 130 µm or 140 µm.Further, the thickness of the annealed surface layer of the semi-insulating silicon carbide single crystal substrate is 80 µm to 120 µm.

Optionally, the high-temperature rapid heat treatment includes a rapid heating stage, and the rapid heating stage includes: raising a temperature to 1,800 °C to 2,300 °C at a rate of 30 °C/s to 100 °C/s, and holding for 60 s to 600 s.

Further, a heating rate of the rapid heating stage is 50 °C/s to 80 °C/s.

Further, the rapid heating stage has a holding temperature of 2,000 °C to 2,200 °C, and a holding period of 100 s to 500 s. Further, the rapid heating stage has a holding temperature of 2,000 °C to 2,100 °C, and a holding period of 150 s to 200 s.

Optionally, the high-temperature rapid heat treatment further includes a rapid cooling stage, and the rapid cooling stage includes: rapidly cooling at a rate of 50 °C/s to 150 °C/s. Further, the rapid cooling stage includes: rapidly cooling at a rate of 100 °C/s to 150 °C/s. The rapid cooling stage can freeze intrinsic point defects injected in the rapid heating stage into the crystal.

In the present application, a certain amount of intrinsic point defects are injected into the high-purity silicon carbide single wafer by the high-temperature rapid heat treatment, to avoid annihilation of excessive intrinsic point defects during a subsequent surface annealing process that affects the semi-insulation property of the prepared semi-insulating silicon carbide single crystal substrate.

In particular, the surface annealing treatment has a surface temperature of the silicon carbide single wafer controlled at 1,200 °C to 1,800 °C, and an annealing treatment period for 30 min to 90 min.

Further, the surface temperature of the high-purity silicon carbide single wafer controlled in the surface annealing treatment has a lower limit selected from 1,250 °C, 1,300 °C, 1,400 °C, 1,500 °C, 1,600 °C, 1,700 °C or 1,750 °C, and an upper limit selected from 1,250 °C, 1,300 °C, 1,400 °C, 1,500 °C, 1,600 °C, 1,700 °C or 1,750 °C.

Further, the period controlled in the surface annealing treatment of the high-purity silicon carbide single wafer has a lower limit selected from 35 min, 45 min, 55 min, 65 min, 75 min or 85 min, and an upper limit selected from 35 min, 45 min, 55 min, 65 min, 75 min or 85 min.

In particular, the surface annealing treatment has a surface temperature of the high-purity silicon carbide single wafer controlled at 1,400 °C to 1,600 °C, and an annealing treatment period for 45 min to 60 min. Further, the surface annealing treatment has a surface temperature of the high-purity silicon carbide single wafer controlled at 1,500 °C to 1,600 °C.

Optionally, the surface annealing treatment includes at least annealing one surface of the high-purity silicon carbide single wafer. Further, the surface annealing treatment includes annealing a contact surface with a GaN crystal when the high-purity silicon carbide single crystal substrate grows the GaN crystal.

Optionally, the surface annealing treatment is heating, by a laser, a surface of the silicon carbide single wafer subjected to the high-temperature rapid heat treatment.

Optionally, the laser heating step includes: performing reciprocating surface scanning by a laser on the high-purity silicon carbide single wafer subjected to the high-temperature rapid heat treatment to perform the surface annealing treatment, a laser movement rate being 0.5 mm/s to 3,000 mm/s. Further, the laser movement rate has a lower limit selected from 1 mm/s, 1,000 mm/s, 1,500 mm/s, 2,000 mm/s or 2,500 mm/s, and an upper limit selected from 5 mm/s, 1,000 mm/s, 1,500 mm/s, 2,000 mm/s or 2,500 mm/s. Further, the laser movement rate is 0.5 mm/s to 5 mm/s. The laser movement rate is such that the laser can heat the substrate surface to a preset temperature but the temperature is not rapidly conducted to the interior of the semi-insulating silicon carbide single crystal substrate, so as to achieve an annealing effect on the surface of the semi-insulating silicon carbide single crystal substrate.

Optionally, the laser has a wavelength less than 352 nm, a pulse width not greater than 60 ns, and an energy density not greater than 150 mJ/cm². In particular, the laser has a wavelength less than 352 nm, a pulse width of 20 ns to 60 ns, and an energy density of 70 mJ/cm² to 110 mJ/cm². The high-purity silicon carbide single wafer surface treated by using the parameters of the laser according to the present application has high uniformity.

Optionally, step 1) the preparation method of the high-purity silicon carbide single wafer includes steps of: preparing a high-purity silicon carbide single crystal after the impurity removal and crystal growth stage of the silicon carbide powder, and then cutting, grinding and polishing the same to prepare the high-purity silicon carbide single wafer.

Advantageous effects of the present application include, but are not limited to that:

The intrinsic point defects in the high-purity silicon carbide single crystal substrate surface layer according to the present application have such a low concentration that GaN fits better with the lattice of the silicon carbide single crystal when the high-purity silicon carbide single crystal is used as an epitaxial substrate of the GaN epitaxy, so that the prepared GaN epitaxial layer has higher quality; and the high-purity silicon carbide single crystal main body layer has internal point defects of a certain concentration such that the semi-insulation property of the high-purity silicon carbide single crystal substrate can be kept.

In the preparation method of the high-purity silicon carbide single crystal substrate according to the present application, the high-temperature rapid heat treatment technology and the surface laser annealing technology are performed on a high-purity semi-insulating silicon carbide substrate, to eliminate point defects introduced into a certain region of the surface of the high-purity semi-insulating silicon carbide substrate, and reserve internal point defects with a distance from the substrate surface at a same time, so that in a defect-free substrate surface layer clean region, the semi-insulation property of the high-purity silicon carbide single crystal substrate is reserved, and the prepared GaN epitaxial layer is optimal in quality.

The high-purity semi-insulating silicon carbide substrate according to the present application balances the relationship between the crystal quality of the GaN epitaxial layer and the electrical properties of the high-purity silicon carbide crystal, and improves the quality of the high-purity silicon carbide single crystal substrate and its lattice fit with the GaN epitaxial layer, without affecting implementation of the physical properties of the high-purity semi-insulating silicon carbide single crystal substrate.

### BRIEF DESCRIPTION OF THE DRAWINGS

FIG. 1 is a schematic diagram of a high-temperature rapid heat treatment in a preparation method of a high-purity silicon carbide single crystal substrate according to the present application.
FIG. 2 is a schematic diagram of a surface annealing treatment in the preparation method of the high-purity silicon carbide single crystal substrate according to the present application.
FIG. 3 is a schematic diagram of concentrations of intrinsic point defects in a high-purity silicon carbide single wafer, a high-purity silicon carbide single wafer subjected to the high-temperature rapid heat treatment, and a high-purity silicon carbide single crystal substrate prepared in the present application.

### DETAILED DESCRIPTION

The present application is described in detail below in conjunction with the embodiments, but the present application is not limited to the embodiments.

Unless otherwise specified, raw materials and the like involved in the embodiments of the present application are all commercially purchased.

The analysis methods according to the embodiment of the present application are as follows:

The resistivity test is carried out with Semimap's COREMA-WT non-contact semi-insulating resistivity tester.

The crystal test is carried out with Horiba's HR800 confocal Raman spectrometer.

The surface test of the silicon carbide single crystal substrate is carried out with FRT's MicroProf@TTV200 automatic surface tester.

The element content test is carried out with Cameca's IMS 7f-Auto secondary ion mass spectrometer.

The high-purity silicon carbide single wafer according to the present application may be prepared just by using a method in the art, and a preparation method of a high-purity silicon carbide single wafer described below may be used, which includes steps of:
① Placing a certain amount of silicon carbide powder in a graphite crucible, wherein, purity of the silicon carbide powder should be above 99.9999%, a concentration of shallow-energy-level donor impurities contained therein such as nitrogen is below 1×10¹⁶ cm⁻³, and a sum of concentrations of shallow-energy-level acceptor impurities such as boron and aluminum should be below 1×10¹⁶cm⁻³;
② Placing a seed crystal for growing the silicon carbide single crystal on an upper portion of the silicon carbide powder inside the graphite crucible, then sealing the graphite crucible; placing the sealed graphite crucible inside graphite thermal insulation felt, transferring the whole system into a single crystal growing apparatus, and then sealing the furnace;
③ Evacuating the furnace so that a pressure therein is 10⁻⁵ Pa, and holding for 5 h to 10 h, to remove residual impurities in the furnace chamber, and then gradually charging a shielding gas such as argon or helium into the furnace chamber;
④ Raising a pressure inside the furnace to 10 mbar to 100 mbar at a rate of 30 mbar/h to 50 mbar/h while increasing a temperature inside the furnace to 2,100 °C to 2,200 °C at a rate of 10 °C/h to 20 °C/h, and holding for 50 h to 100 h at the temperature, to complete the growth process of the silicon carbide single crystal; and
(5) Discontinuing heating the furnace after the end of the single crystal growth process; after the furnace temperature is naturally lowered to room temperature, opening the furnace and taking out the graphite crucible, to obtain the high-purity silicon carbide single crystal; and then continuing a cutting and polishing process to obtain the high-purity silicon carbide single wafer.

### Embodiment 1: Preparation of high-purity silicon carbide single crystal substrate

As an implementation mode, the preparation method of the high-purity silicon carbide single wafer includes steps of:
① Placing a certain amount of silicon carbide powder in a graphite crucible, wherein, purity of the silicon carbide powder should be above 99.9999%, a concentration of shallow-energy-level donor impurities contained therein such as nitrogen is below 1×10¹⁶ cm⁻³, and a sum of concentrations of shallow-energy-level acceptor impurities such as boron and aluminum should be below 1×10¹⁶cm⁻³;
② Placing a seed crystal for growing the silicon carbide single crystal on an upper portion of the silicon carbide powder inside the graphite crucible, then sealing the graphite crucible; placing the sealed graphite crucible inside graphite thermal insulation felt, transferring the whole system into a single crystal growing apparatus, and then sealing the furnace;
③ Evacuating the furnace so that a pressure therein is 10⁻⁵ Pa, and holding for 8 h, to remove residual impurities in the furnace chamber, and then gradually charging an argon gas into the furnace chamber;
④ Raising a pressure inside the furnace to 50 mbar at a rate of 40 mbar/h while increasing a temperature inside the furnace to 2,100 °C to 2,200 °C at a rate of 15 °C/h, and holding for 80 h at the temperature, to complete the growth process of the silicon carbide single crystal; and
(5) Discontinuing heating the furnace after the end of the single crystal growth process; after the furnace temperature is naturally lowered to room temperature, opening the furnace and taking out the graphite crucible, to obtain the high-purity silicon carbide single crystal; and then continuing a cutting and polishing process to obtain high-purity silicon carbide single wafer 1#.

The high-purity silicon carbide single crystal substrate is prepared from high-purity silicon carbide single wafer 1# prepared by using the above-described method, and the preparation method comprises steps of:
Performing a high-temperature rapid heat treatment on the prepared high-purity silicon carbide single wafer and performing reciprocating surface scanning by a laser on a surface of the high-purity silicon carbide single wafer to anneal the same, so as to obtain the high-purity silicon carbide single crystal substrate.

A temperature of the surface of the high-purity silicon carbide single wafer is controlled by controlling values of laser power, defocusing amount and laser heat treatment area, etc.

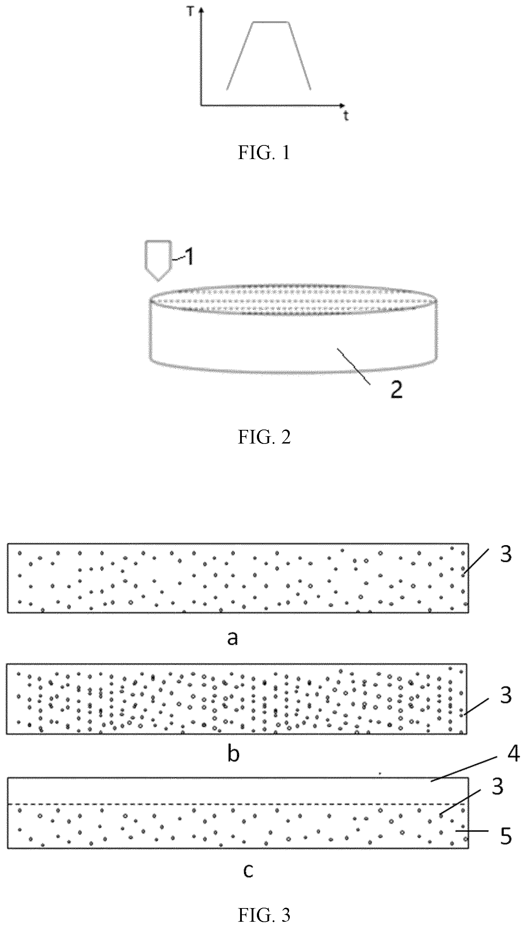

A schematic diagram of the high-temperature rapid heat treatment of the preparation method of the high-purity silicon carbide single crystal substrate according to this embodiment is shown in FIG. 1, where, T is temperature, and t is time.

A schematic diagram of the surface annealing treatment of the preparation method of the high-purity silicon carbide single crystal substrate according to this embodiment is shown in FIG. 2, wherein, 1 is a laser, 2 is the high-purity silicon carbide single wafer, and the laser 1 reciprocates at a certain rate on the surface of the high-purity silicon carbide single wafer 2 to heat the surface of the high-purity silicon carbide single wafer 2.

A schematic diagram of concentration variation of intrinsic point defects from the semi-insulating silicon carbide single wafer to the high-purity silicon carbide single crystal substrate product is shown in FIG. 3 , wherein, schematic diagrams of concentrations of intrinsic point defects in the high-purity silicon carbide single wafer, the high-purity silicon carbide single wafer subjected to the high-temperature rapid heat treatment and the high-purity silicon carbide single crystal substrate are respectively shown in FIG. 3a, FIG. 3b and FIG. 3c. Wherein, number 3 in FIG. 3 denotes an intrinsic point defect, number 4 denotes a high-purity silicon carbide single crystal substrate surface layer, and number 5 denotes a high-purity silicon carbide single crystal main body layer. In the present application, a certain amount of intrinsic point defects 3 (as shown in FIG. 3b) are injected into the high-purity silicon carbide single wafer (as shown in FIG. 3a) by the high-temperature rapid heat treatment, to avoid annihilation of excessive intrinsic point defects 3 during a subsequent surface annealing process that affects the semi-insulation property of the prepared silicon carbide single crystal substrate (as shown in FIG. 3c). In the preparation method of the high-purity silicon carbide single crystal substrate (as shown in FIG. 3c) according to the present application, the high-temperature rapid heat treatment technology and the surface laser annealing technology are performed on a high-purity semi-insulating silicon carbide substrate, to eliminate point defects introduced into a certain region of the surface 4 of the high-purity semi-insulating silicon carbide substrate, and at a same time, reserve internal point defects with a distance from the substrate surface, i.e., the high-purity silicon carbide single crystal main body layer 5, so that in a clean region of a defect-free substrate surface layer 4, the semi-insulation property of the semi-insulating silicon carbide substrate is reserved, and the GaN epitaxial layer is optimal in quality.

KrF pulse laser irradiation is used to anneal the high-purity silicon carbide single crystal substrate, to control an energy density of the high-purity silicon carbide single crystal substrate to be not greater than 150 mJ/cm².

According to the above-described method and specific parameters shown in Table 1, high-purity silicon carbide single wafer 1# is respectively prepared into high-purity silicon carbide single crystal substrate 1#, high-purity silicon carbide single crystal substrate 2#, high-purity silicon carbide single crystal substrate 3#, high-purity silicon carbide single crystal substrate 4# and high-purity silicon carbide single crystal substrate 5#. The specific preparation parameters and substrate properties of high-purity silicon carbide single crystal substrates 1# to 5# are shown in Table 1.

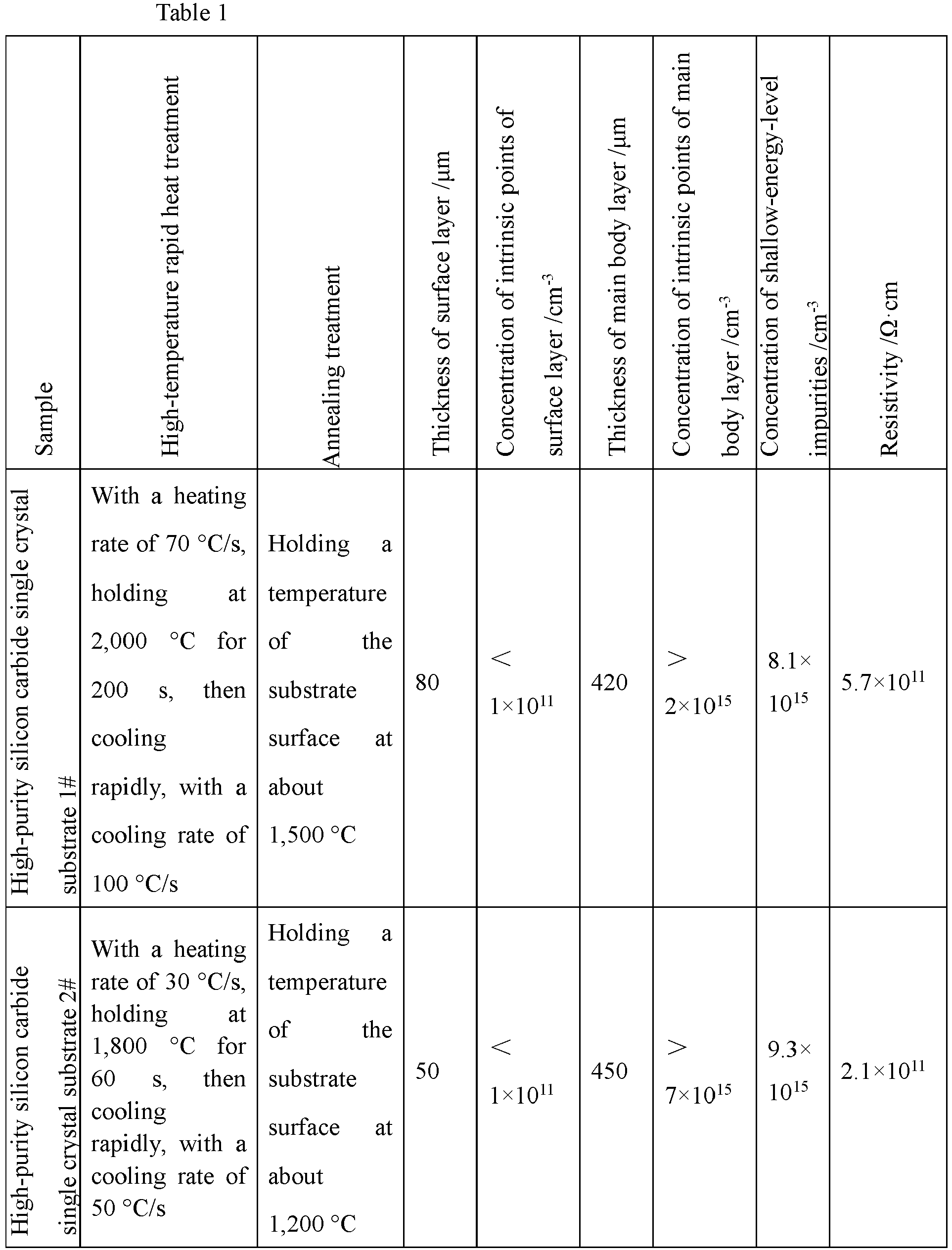

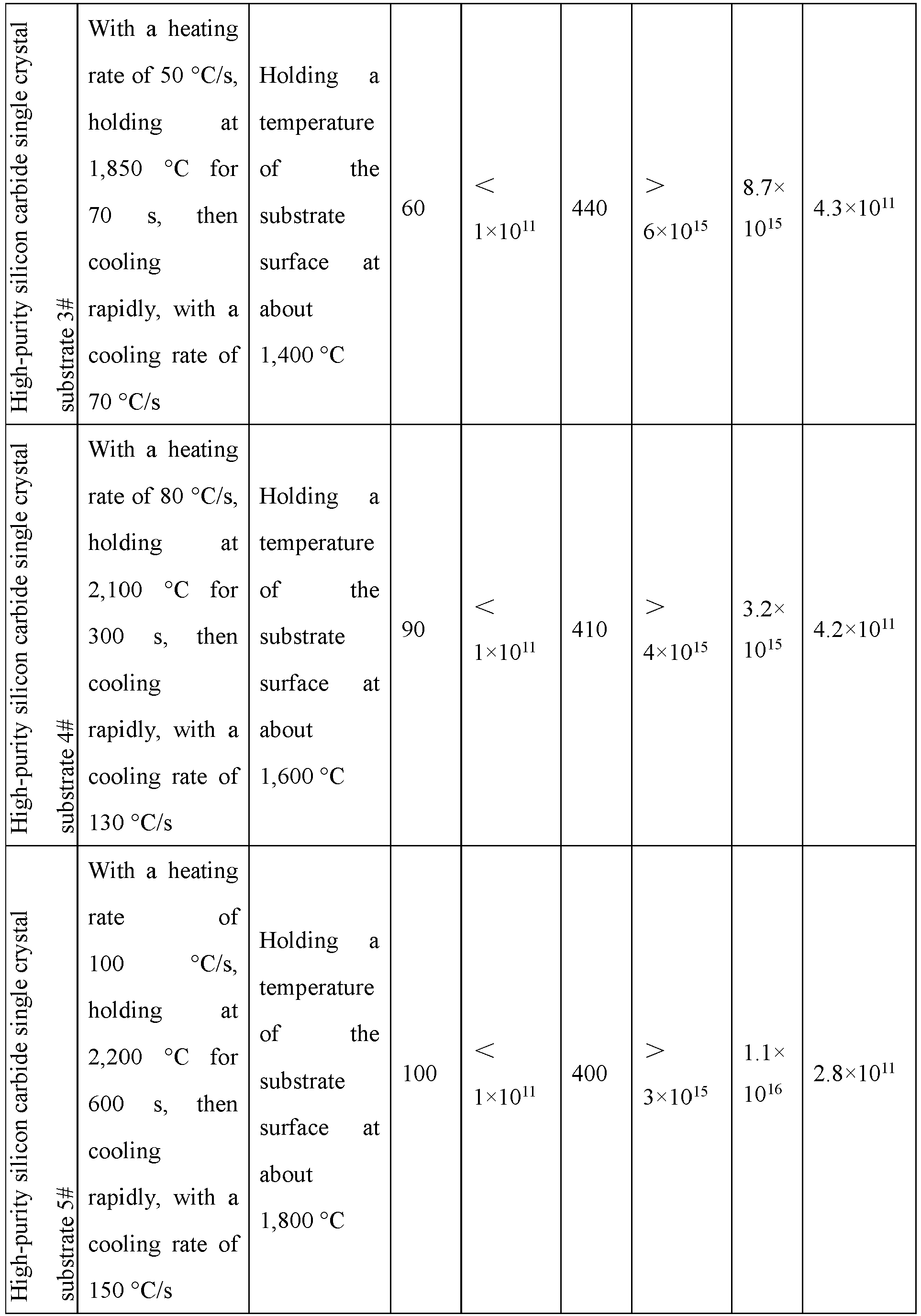

Resistivity values, shallow-energy-level impurity contents, intrinsic point concentrations of silicon carbide substrate surface layers, and intrinsic point concentrations of silicon carbide substrate main body layers, etc., of high-purity silicon carbide single crystal substrate 1#, high-purity silicon carbide single crystal substrate 2#, high-purity silicon carbide single crystal substrate 3#, high-purity silicon carbide single crystal substrate 4# and high-purity silicon carbide single crystal substrate 5# prepared are respectively tested, and test results are as shown in Table 1. It can be known from data in Table 1 that high-purity silicon carbide single crystal substrates 1# to 5# have high resistivity values and have a semi-insulation property. High-purity silicon carbide single crystal substrates 1# to 5# have an intrinsic point defect concentration of a silicon carbide single crystal substrate surface layer smaller than an intrinsic point defect concentrations of a silicon carbide single crystal substrate main body layer, and the prepared silicon carbide single crystal substrates 1# to 5# have a semi-insulation property. Wherein, high-purity silicon carbide single crystal substrate 1# has an extremely low intrinsic point defect concentration in the surface layer, and thus has good lattice integrity; and high-purity silicon carbide single crystal substrate 1# has such an intrinsic point defect concentration in the main body layer that the high-purity silicon carbide single crystal substrate has a semi-insulation property. The intrinsic point defect concentration of the silicon carbide single crystal substrate surface layer is extremely low; there are always intrinsic point defects present in the crystal unless at the absolute zero degree, and the defect has a lowest concentration within a certain thickness.

Resistivity values of 4-to-12-inch semi-insulating silicon carbide single crystal substrates prepared in the embodiment of the present application can reach above 2×10¹¹ Ω•cm, and resistivity radial distributions are controlled within 2 orders of magnitude, so as to implement uniform resistivity distributions of the semi-insulating silicon carbide single crystal substrates. Bow and Warp are tested for the 4-to-12-inch semi-insulating silicon carbide single crystal substrates, and values of Bow and Warp thereof can be controlled within 45 µm.

### Embodiment 2: Preparation of GaN single crystal and performance test

Equal-sized high-purity silicon carbide single crystal substrates 1# to 5# and high-purity silicon carbide single wafer 1# prepared in Embodiment 1 are respectively used as bases for preparing a GaN single crystal epitaxial wafer, and a preparation method is a conventional method in the art. Crystal quality of the GaN single crystal prepared from high-purity silicon carbide single crystal substrates 1# to 5# is higher than quality of the GaN single crystal epitaxial wafer prepared with high-purity silicon carbide single wafer 1# as a base, and specific data is as shown in table 2.

**Table 2**

| Sample | Features of GaN single crystal epitaxial wafer prepared |
|---|---|
| High-purity silicon carbide single crystal substrate 1# | (002) Half height and width of surface rocking curve: arcsec 108 |
| | (102) Half height and width of surface rocking curve: arcsec 196 |
| High-purity silicon carbide single crystal substrate 2# | (002) Half height and width of surface rocking curve: arcsec 136 |
| | (102) Half height and width of surface rocking curve: arcsec 230 |
| High-purity silicon carbide single crystal substrate 3# | (002) Half height and width of surface rocking curve: arcsec 113 |
| | (102) Half height and width of surface rocking curve: arcsec 227 |
| High-purity silicon carbide single crystal substrate 4# | (002) Half height and width of surface rocking curve: arcsec 120 |
| | (102) Half height and width of surface rocking curve: arcsec 221 |
| High-purity silicon carbide single crystal substrate 5# | (002) Half height and width of surface rocking curve: arcsec 119 |
| | (102) Half height and width of surface rocking curve: arcsec 218 |
| High-purity silicon carbide single wafer 1# | (002) Half height and width of surface rocking curve: arcsec 134 |
| | (102) Half height and width of surface rocking curve: arcsec 226 |

The above are only embodiments of the present application, but the scope of the present application is not limited by these specific embodiments, and is determined by the claims of the present application. Various changes and modifications may be made to the present application by those skilled in the art.

## Claims

1. A high-purity silicon carbide single crystal substrate, at least comprising a silicon carbide single crystal substrate surface layer (4) and a silicon carbide single crystal substrate main body layer (5); an intrinsic point defect concentration of the silicon carbide single crystal substrate surface layer (4) is smaller than an intrinsic point defect concentration of the silicon carbide single crystal substrate main body layer (5); wherein the intrinsic point defect concentration of the silicon carbide single crystal substrate surface layer (4) at room temperature is not higher than 1×10¹³ cm⁻³, and the intrinsic point defect concentration of the silicon carbide single crystal substrate main body layer (5) is 1×10¹⁴ cm⁻³ to 1×10¹⁶ cm⁻³; and the silicon carbide single crystal substrate main body layer (5) has such an intrinsic point defect concentration that the silicon carbide single crystal substrate has a semi-insulation property.

2. The high-purity silicon carbide single crystal substrate according to claim 1, wherein, a ratio of a thickness of the silicon carbide single crystal substrate surface layer (4) to a thickness of the silicon carbide single crystal substrate main body layer (5) is 1:4 to 1:25.

3. The high-purity silicon carbide single crystal substrate according to claim 1, wherein,
the intrinsic point defect concentration of the silicon carbide single crystal substrate surface layer (4) at room temperature is not higher than 1×10¹² cm⁻³, and the intrinsic point defect concentration of the silicon carbide single crystal substrate main body layer (5) is 1×10¹⁴ cm⁻³ to 1×10¹⁵ cm⁻³.

4. The high-purity silicon carbide single crystal substrate according to claim 1, wherein, a thickness of the silicon carbide single crystal substrate surface layer (4) is not greater than 150 µm;
in particular, a thickness of the silicon carbide single crystal substrate surface layer is 20 µm to 150 µm.

5. The high-purity silicon carbide single crystal substrate according to any one of claims 1 to 4, wherein, the substrate is prepared by using a preparation method below:
performing a high-temperature rapid heat treatment and a surface annealing treatment on a high-purity silicon carbide single wafer, to obtain the high-purity silicon carbide single crystal substrate.

6. The high-purity silicon carbide single crystal substrate according to claim 5, wherein, the high-temperature rapid heat treatment includes a rapid heating stage and a rapid cooling stage;
in particular, the rapid heating stage includes steps of: raising a temperature to 1,800 °C to 2,200 °C at a rate of 30 °C/s to 100 °C/s, holding for 60 s to 600 s; and the rapid cooling stage includes steps of: rapidly cooling to room temperature at a rate of 50 °C/s to 150 °C/s.

7. The high-purity silicon carbide single crystal substrate according to claim 5, wherein, the surface annealing treatment has a surface temperature of the silicon carbide single wafer controlled at 1,200 °C to 1,800 °C, and an annealing treatment period for 30 min to 90 min.

8. The high-purity silicon carbide single crystal substrate according to claim 7, wherein the surface annealing treatment is heating, by a surface laser, a surface of the silicon carbide single wafer subjected to the high-temperature rapid heat treatment;
the laser heating step includes: performing reciprocating surface scanning by a laser on the silicon carbide single wafer subjected to the high-temperature rapid heat treatment to perform the surface annealing treatment, a laser movement rate being 0.5 mm/s to 3,000 mm/s.

9. A semiconductor device, comprising the high-purity silicon carbide single crystal substrate according to any one of claims 1 to 8;
in particular, the semiconductor device is an epitaxial wafer or a transistor.

10. A preparation method of a high-quality semi-insulating silicon carbide single crystal substrate according to any of claims 1 to 9, comprising steps of:
1) selecting a high-purity silicon carbide single wafer;
2) performing a high-temperature rapid heat treatment and a surface annealing treatment on the high-purity silicon carbide single wafer to obtain the high-quality semi-insulating silicon carbide single crystal substrate;
the high-quality semi-insulating silicon carbide single crystal substrate at least comprising a silicon carbide single crystal substrate surface layer (4) and a silicon carbide single crystal substrate main body layer (5).

11. The preparation method according to claim 10, wherein, the high-temperature rapid heat treatment includes a rapid heating stage, and the rapid heating stage includes: raising a temperature to 1,800 °C to 2,300 °C at a rate of 30 °C/s to 100 °C/s, and holding for 60 s to 600 s, wherein the high-temperature rapid heat treatment further includes a rapid cooling stage, and the rapid cooling stage includes: rapidly cooling at a rate of 50 °C/s to 150 °C/s.

12. The preparation method according to claim 10, wherein, the surface annealing treatment has a surface temperature of the high-purity silicon carbide single wafer controlled at 1,200 °C to 1,800 °C, and an annealing treatment period for 30 min to 90 min;
in particular, the surface annealing treatment has a surface temperature of the high-purity silicon carbide single wafer controlled at 1,400 °C to 1,600 °C, and an annealing treatment period for 45 min to 60 min.

13. The preparation method according to claim 10, wherein, the surface annealing treatment is heating, by a laser, a surface of the high-purity silicon carbide single wafer subjected to the high-temperature rapid heat treatment, wherein the laser heating step includes: performing reciprocating surface scanning by a laser on the high-purity silicon carbide single wafer subjected to the high-temperature rapid heat treatment to perform the surface annealing treatment, a laser movement rate being 0.5 mm/s to 3,000 mm/s;
in particular, the laser movement rate is 0.5 mm/s to 5 mm/s.

14. The preparation method according to claim 13, wherein, the laser has a wavelength less than 352 nm, a pulse width not greater than 60 ns, and an energy density not greater than 150 mJ/cm²;
in particular, the laser has a wavelength less than 352 nm, a pulse width of 20 ns to 60 ns, and an energy density of 70 mJ/cm² to 110 mJ/cm².

## Patentansprüche

1. Einkristallsubstrat aus hochreinem Siliciumcarbid, mindestens eine Oberflächenschicht (4) des Einkristallsubstrats aus Siliciumcarbid und eine Hauptkörperschicht (5) des Einkristallsubstrats aus Siliciumcarbid umfassend; wobei eine intrinsische Punktdefektkonzentration der Oberflächenschicht (4) des Einkristallsubstrats aus Siliciumcarbid kleiner ist als eine intrinsische Punktdefektkonzentration der Hauptkörperschicht (5) des Einkristallsubstrats aus Siliciumcarbid; wobei die intrinsische Punktdefektkonzentration der Oberflächenschicht (4) des Einkristallsubstrats aus Siliciumcarbid bei Raumtemperatur nicht höher als 1×10¹³ cm⁻³ ist und die intrinsische Punktdefektkonzentration der Hauptkörperschicht (5) des Einkristallsubstrats aus Siliciumcarbid 1×10¹⁴ cm⁻³ bis 1×10¹⁶ cm⁻³ beträgt; und die Hauptkörperschicht (5) des Einkristallsubstrats aus Siliciumcarbid eine solche intrinsische Punktdefektkonzentration aufweist, dass das Einkristallsubstrat aus Siliciumcarbid eine halbisolierende Eigenschaft aufweist.

2. Einkristallsubstrat aus hochreinem Siliciumcarbid nach Anspruch 1, wobei ein Verhältnis einer Dicke der Oberflächenschicht (4) des Einkristallsubstrats aus Siliciumcarbid zu einer Dicke der Hauptkörperschicht (5) des Einkristallsubstrats aus Siliciumcarbid 1:4 bis 1:25 beträgt.

3. Einkristallsubstrat aus hochreinem Siliciumcarbid nach Anspruch 1, wobei,
die intrinsische Punktdefektkonzentration der Oberflächenschicht (4) des Einkristallsubstrats aus Siliciumcarbid bei Raumtemperatur nicht höher 1×10¹² cm⁻³ ist und die intrinsische Punktdefektkonzentration der Hauptkörperschicht (5) des Einkristallsubstrats aus Siliciumcarbid 1×10¹⁴ cm⁻³ bis 1×10¹⁵ cm⁻³ beträgt.

4. Einkristallsubstrat aus hochreinem Siliciumcarbid nach Anspruch 1, wobei eine Dicke der Oberflächenschicht (4) des Einkristallsubstrats aus Siliciumcarbid nicht größer als 150 µm ist;
wobei insbesondere eine Dicke der Oberflächenschicht des Einkristallsubstrats aus Siliciumcarbid 20 µm bis 150 µm beträgt.

5. Einkristallsubstrat aus hochreinem Siliciumcarbid nach einem der Ansprüche 1 bis 4, wobei das Substrat unter Verwendung eines der folgenden Herstellungsverfahren hergestellt ist:
Durchführen einer Hochtemperatur-Schnellerwärmungsbehandlung und einer Oberflächenglühbehandlung an einem Einzelwafer aus hochreinem Siliciumcarbid, um das Einkristallsubstrat aus hochreinem Siliciumcarbid zu erhalten.

6. Einkristallsubstrat aus hochreinem Siliciumcarbid nach Anspruch 5, wobei die Hochtemperatur-Schnellerwärmungsbehandlung eine Schnellerwärmungsstufe und eine Schnellabkühlstufe enthält;
wobei insbesondere die Schnellerwärmungsstufe die folgenden Schritte enthält: Erhöhen einer Temperatur auf 1.800 °C bis 2.200 °C mit einer Geschwindigkeit von 30 °C/s bis 100 °C/s, Halten für 60 s bis 600 s; und die Schnellabkühlstufe die folgenden Schritte enthält: schnelles Abkühlen auf Raumtemperatur mit einer Geschwindigkeit von 50 °C/s bis 150 °C/s.

7. Einkristallsubstrat aus hochreinem Siliciumcarbid nach Anspruch 5, wobei die Oberflächenglühbehandlung eine auf 1.200 °C bis 1.800 °C gesteuerte Oberflächentemperatur des Einzelwafers aus Siliciumcarbid und eine Glühbehandlungsdauer von 30 min bis 90 min aufweist.

8. Einkristallsubstrat aus hochreinem Siliciumcarbid nach Anspruch 7, wobei es sich bei der Oberflächenglühbehandlung um Erwärmen einer Oberfläche des Einzelwafers aus Siliciumcarbid, der der Hochtemperatur-Schnellerwärmungsbehandlung unterzogen wurde, durch einen Oberflächenlaser handelt;
wobei der Schritt der Lasererwärmung Folgendes enthält: Durchführen einer hin- und hergehenden Oberflächenabtastung durch einen Laser an dem Einzelwafer aus Siliciumcarbid, der der Hochtemperatur-Schnellerwärmungsbehandlung unterzogen wurde, um die Oberflächenglühbehandlung durchzuführen, wobei die Laserbewegungsgeschwindigkeit 0,5 mm/s bis 3.000 mm/s beträgt.

9. Halbleitervorrichtung, umfassend das Einkristallsubstrat aus hochreinem Siliciumcarbid nach einem der Ansprüche 1 bis 8;
insbesondere wobei die Halbleitervorrichtung ein Epitaxiewafer oder ein Transistor ist.

10. Verfahren zum Herstellen eines hochwertigen halbisolierenden Einkristallsubstrats aus Siliciumcarbid nach einem der Ansprüche 1 bis 9, umfassend die folgenden Schritte:
1) Auswählen eines Einzelwafers aus hochreinem Siliciumcarbid;
2) Durchführen einer Hochtemperatur-Schnellerwärmungsbehandlung und einer Oberflächenglühbehandlung an dem Einzelwafer aus hochreinem Siliciumcarbid, um das hochwertige halbisolierende Einkristallsubstrat aus Siliciumcarbid zu erhalten;
wobei das hochwertige halbisolierende Einkristallsubstrat aus Siliciumcarbid mindestens eine Oberflächenschicht (4) des Einkristallsubstrats aus Siliciumcarbid und eine Hauptkörperschicht (5) des Einkristallsubstrats aus Siliciumcarbid umfasst.

11. Herstellungsverfahren nach Anspruch 10, wobei die Hochtemperatur-Schnellerwärmungsbehandlung eine Schnellerwärmungsstufe enthält und wobei die Schnellerwärmungsstufe Folgendes enthält: Erhöhen einer Temperatur auf 1.800 °C bis 2.300 °C mit einer Geschwindigkeit von 30 °C/s bis 100 °C/s, und Halten für 60 s bis 600 s, wobei die Hochtemperatur-Schnellerwärmungsbehandlung ferner eine Schnellabkühlstufe enthält und die Schnellabkühlstufe Folgendes enthält: schnelles Abkühlen mit einer Geschwindigkeit von 50 °C/s bis 150 °C/s.

12. Herstellungsverfahren nach Anspruch 10, wobei die Oberflächenglühbehandlung eine auf 1.200 °C bis 1.800 °C gesteuerte Oberflächentemperatur des Einzelwafers aus hochreinem Siliciumcarbid und eine Glühbehandlungsdauer von 30 min bis 90 min aufweist;
wobei die Oberflächenglühbehandlung insbesondere eine auf 1.400 °C bis 1.600 °C gesteuerte Oberflächentemperatur des Einzelwafers aus hochreinem Siliciumcarbid und eine Glühbehandlungsdauer von 45 min bis 60 min aufweist.

13. Herstellungsverfahren nach Anspruch 10, wobei es sich bei der Oberflächenglühbehandlung um Erwärmen einer Oberfläche des Einzelwafers aus hochreinem Siliciumcarbid, der der Hochtemperatur-Schnellerwärmungsbehandlung unterzogen wurde, durch einen Laser handelt, wobei der Schritt der Lasererwärmung Folgendes enthält: Durchführen einer hin- und hergehenden Oberflächenabtastung durch einen Laser an dem Einzelwafer aus hochreinem Siliciumcarbid, der der Hochtemperatur-Schnellerwärmungsbehandlung unterzogen wurde, um die Oberflächenglühbehandlung durchzuführen, wobei die Laserbewegungsgeschwindigkeit 0,5 mm/s bis 3.000 mm/s beträgt;
wobei insbesondere die Laserbewegungsgeschwindigkeit 0,5 mm/s bis 5 mm/s beträgt.

14. Herstellungsverfahren nach Anspruch 13, wobei der Laser eine Wellenlänge von weniger als 352 nm, eine Impulsbreite von nicht mehr als 60 ns und eine Energiedichte von nicht mehr als 150 mJ/cm² aufweist;
wobei der Laser insbesondere eine Wellenlänge von weniger als 352 nm, eine Impulsbreite von 20 ns bis 60 ns und eine Energiedichte von 70 mJ/cm² bis 110 mJ/cm² aufweist.

## Revendications

1. Substrat monocristallin de carbure de silicium de haute pureté, comprenant au moins une couche de surface (4) de substrat monocristallin de carbure de silicium et une couche de corps principal (5) de substrat monocristallin de carbure de silicium ; une concentration de défauts de points intrinsèques de la couche de surface (4) de substrat monocristallin de carbure de silicium est inférieure à une concentration de défauts de points intrinsèques de la couche de corps principal (5) de substrat monocristallin de carbure de silicium ; ladite concentration de défauts de points intrinsèques de la couche de surface (4) de substrat monocristallin de carbure de silicium à température ambiante n'étant pas supérieure à 1×10¹³ cm⁻³, et ladite concentration de défauts de points intrinsèques de la couche de corps principal (5) de substrat monocristallin de carbure de silicium étant de 1×10¹⁴ cm⁻³ à 1×10¹⁶ cm⁻³ ; et ladite couche de corps principal (5) de substrat monocristallin de carbure de silicium comportant une telle concentration de défauts de points intrinsèques que le substrat monocristallin de carbure de silicium comporte une propriété semi-isolante.

2. Substrat monocristallin de carbure de silicium de haute pureté selon la revendication 1,
ledit rapport de l'épaisseur de la couche de surface (4) de substrat monocristallin de carbure de silicium sur l'épaisseur de la couche de corps principal (5) de substrat monocristallin de carbure de silicium étant de 1:4 à 1:25.

3. Substrat monocristallin de carbure de silicium de haute pureté selon la revendication 1,
ladite concentration de défauts de points intrinsèques de la couche de surface (4) de substrat monocristallin de carbure de silicium à température ambiante n'étant pas supérieure à 1×10¹² cm⁻³, et ladite concentration de défauts de points intrinsèques de la couche de corps principal (5) de substrat monocristallin de carbure de silicium étant de 1×10¹⁴ cm⁻³ à 1×10¹⁵ cm⁻³.

4. Substrat monocristallin de carbure de silicium de haute pureté selon la revendication 1,
ladite épaisseur de la couche de surface (4) de substrat monocristallin de carbure de silicium n'étant pas supérieure à 150 µm ;
en particulier, l'épaisseur de la couche de surface du substrat monocristallin de carbure de silicium étant de 20 µm à 150 µm.

5. Substrat monocristallin de carbure de silicium de haute pureté selon l'une quelconque des
revendications 1 à 4, ledit substrat étant préparé à l'aide d'un procédé de préparation ci-dessous : la réalisation d'un traitement thermique rapide à haute température et d'un traitement de recuit de surface sur une tranche unique de carbure de silicium de haute pureté, pour obtenir le substrat monocristallin de carbure de silicium de haute pureté.

6. Substrat monocristallin de carbure de silicium de haute pureté selon la revendication 5,
ledit traitement thermique rapide à haute température comprenant une étape de chauffage rapide et une étape de refroidissement rapide ;
en particulier, ladite étape de chauffage rapide comprenant les étapes de : augmentation d'une température de 1 800°C à 2 200°C à un taux de 30°C/s à 100°C/s, maintien pendant 60 s à 600 s ; et ladite étape de refroidissement rapide comprenant les étapes de : refroidissement rapide jusqu'à température ambiante à un taux de 50°C/s à 150°C/s.

7. Substrat monocristallin de carbure de silicium de haute pureté selon la revendication 5,
ledit traitement de recuit de surface comportant une température de surface de la tranche unique de carbure de silicium régulée à 1 200°C jusqu'à 1 800°C, et une période de traitement de recuit allant de 30 min à 90 min.

8. Substrat monocristallin de carbure de silicium de haute pureté selon la revendication 7,
ledit traitement de recuit de surface étant le chauffage, au moyen d'un laser de surface, d'une surface de la tranche unique de carbure de silicium soumise au traitement thermique rapide à haute température ;
ladite étape de chauffage au laser comprenant : la réalisation d'un balayage de surface alternatif par un laser sur la tranche unique de carbure de silicium soumise au traitement thermique rapide à haute température pour réaliser le traitement de recuit de surface, une vitesse de déplacement du laser étant de 0,5 mm/s à 3 000 mm/s.

9. Dispositif semi-conducteur, comprenant le substrat monocristallin de carbure de silicium de haute pureté
selon l'une quelconque des revendications 1 à 8,
en particulier, le dispositif semi-conducteur est une tranche épitaxiale ou un transistor.

10. Procédé de préparation d'un substrat monocristallin de carbure de silicium semi-isolant de haute qualité selon l'une quelconque des revendications 1 à 9, comprenant les étapes de :
1) sélection d'une tranche unique de carbure de silicium de haute pureté ;
2) réalisation d'un traitement thermique rapide à haute température et d'un traitement de recuit de surface sur la tranche unique de carbure de silicium de haute pureté pour obtenir le substrat monocristallin de carbure de silicium semi-isolant de haute qualité ;
le substrat monocristallin de carbure de silicium semi-isolant de haute qualité comprenant au moins une couche de surface (4) de substrat monocristallin de carbure de silicium et une couche de corps principal (5) de substrat monocristallin de carbure de silicium.

11. Procédé de préparation selon la revendication 10, ledit traitement thermique rapide à haute température comprenant une étape de chauffage rapide, et ladite étape de chauffage rapide comprenant : l'augmentation d'une température à une température de 1 800°C à 2 300°C à un taux de 30°C/s à 100°C/s, et le maintien pendant 60 s à 600 s, ledit traitement thermique rapide à haute température comprenant en outre une étape de refroidissement rapide, et ladite étape de refroidissement rapide comprenant : un refroidissement rapide à un taux de 50°C/s à 150°C/s.

12. Procédé de préparation selon la revendication 10, ledit traitement de recuit de surface comportant une température de surface de la tranche unique de carbure de silicium de haute pureté régulée à une température de 1 200°C à 1 800°C, et une période de traitement de recuit de 30 min à 90 min ;
en particulier, ledit traitement de recuit de surface comportant une température de surface de la tranche unique de carbure de silicium de haute pureté régulée à une température de 1 400°C à 1 600°C, et une période de traitement de recuit de 45 min à 60 min.

13. Procédé de préparation selon la revendication 10, ledit traitement de recuit de surface étant le chauffage, par un laser, d'une surface de la tranche unique de carbure de silicium de haute pureté soumise au traitement thermique rapide à haute température, ladite étape de chauffage au laser comprenant : la réalisation d'un balayage de surface alternatif par un laser sur la tranche unique de carbure de silicium de haute pureté soumise au traitement thermique rapide à haute température pour réaliser le traitement de recuit de surface, une vitesse de déplacement du laser étant de 0,5 mm/s à 3 000 mm/s ;
en particulier, ladite vitesse de déplacement du laser étant de 0,5 mm/s à 5 mm/s.

14. Procédé de préparation selon la revendication 13, ledit laser comportant une longueur d'onde inférieure à 352 nm, une largeur d'impulsion non supérieure à 60 ns et une densité d'énergie non supérieure à 150 mJ/cm² ;
en particulier, ledit laser comportant une longueur d'onde inférieure à 352 nm, une largeur d'impulsion de 20 ns à 60 ns et une densité d'énergie de 70 mJ/cm² à 110 mJ/cm².
